Europäisches Patentamt

European Patent Office

Office européen des brevets

(19)

(11) Numéro de publication: **0 082 089**
**A2**

(12) **DEMANDE DE BREVET EUROPEEN**

(21) Numéro de dépôt: **82402315.4**

(51) Int. Cl.³: **H 01 J 37/32**

(22) Date de dépôt: **16.12.82**

(30) Priorité: **16.12.81 FR 8123537**

(43) Date de publication de la demande: **22.06.83**
**Bulletin 83/25**

(84) Etats contractants désignés: **CH DE GB IT LI**

(71) Demandeur: **ATELIER D'ELECTROTHERMIE ET DE CONSTRUCTIONS SPECIALES (AET) Société anonyme dite, F-38240 Meylan (FR)**

(72) Inventeur: **Penelon, Joel Alfred, 38 Chemin de la Taillat, F-38240 Meylan (FR)**

(74) Mandataire: **Casalonga, Axel et al, BUREAU D.A. CASALONGA OFFICE JOSSE & PETIT Baaderstrasse 12-14, D-8000 München 5 (DE)**

(54) Procédé pour générer un plasma et dispositif pour la mise en oeuvre de ce procédé.

(57) Procédé pour générer un plasma en vue du traitement d'un substrat dans lequel on produit la décharge luminescente à l'aide d'une onde électrique produite par communication, quasi-commutation ou découpage, cette onde présentant des temps mort.

Dispositif pour la mise en oeuvre de ce procédé comprenant une enceinte (2), deux électrodes (7, 8) et un générateur électrique (3) présentant une source de tension continue (11) et un circuit d'adaptation et de commutation (12, 17, 18) produisant une onde électrique alternative. rectangulaire et présentent des temps morts.

EP 0 082 089 A2

"Procédé pour générer un plasma et dispositif pour la mise en oeuvre de ce procédé".

————————

La présente invention concerne un procédé et un dispositif pour générer dans une enceinte un plasma destiné à effectuer le traitement d'un substrat disposé dans cette enceinte, dans lesquels on produit une décharge luminescente dans un gaz ou un mélange gazeux introduit dans l'enceinte, cette décharge ayant pour effet de rompre les liaisons moléculaires des espèces gazeuses en vue d'effectuer le traitement du substrat.

Dans les procédés et dispositifs de ce genre actuellement connus, on utilise, pour produire la décharge luminescente, un générateur électrique qui fournit des signaux électriques du type sinusoïdal ou des signaux électriques de forme périodique dont l'allure ne peut pas être préalablement déterminée. On utilise en général comme générateur de signaux électriques sinusoïdaux des oscillateurs qui excitent le mélange gazeux à une radio-fréquence. Selon la pratique actuelle, pour faire varier les puissances, on fonctionne à une fréquence fixe déterminée et on fait varier l'amplitude des signaux électriques.

Les procédés et dispositifs actuellement utilisés présentent de nombreux inconvénients. En effet, l'utilisation de tels générateurs a un mauvais rendement énergétique et ne permet pas d'obtenir des plasmas très stables. En conséquence, les substrats traités ne sont pas homogènes et les résultats obtenus ne peuvent pas être considérés comme reproductibles. De plus, les générateurs actuels sont chers, encombrants et fragiles.

La présente invention a notamment pour but de remédier à ces inconvénients. Elle propose en effet un procédé et un dispositif pour générer dans une enceinte un plasma susceptible d'être produit à l'aide d'une onde électrique de fréquence comprise notamment entre 0 et 1 Méga Herz et de forme déterminée, particulière et facilement ajustable ou régulable en vue d'adapter le plasma au traitement recherché en favorisant notamment la fabrication, la répartition et la diffusion de certaines espèces particulières de manière à obtenir le résultat recherché.

Le procédé et le dispositif selon la présente invention peuvent être utilisés pour tout traitement à effectuer sur tout substrat. Ils peuvent en effet être utilisés notamment pour tout traitement de surface tel que dépôt, gravure ou décapage et notamment lors des opérations de fabrication de semi-conducteurs, de circuits intégrés ou de circuits hybrides.

En outre, le procédé et le dispositif selon la présente invention peuvent être utilisés aussi bien pour la production d'un plasma de type froid que pour la production d'un plasma de type chaud.

La présente invention a donc tout d'abord pour objet un procédé qui permet de générer un plasma destiné à effectuer le traitement d'au moins un substrat dans lequel on produit une décharge luminescente entre deux électrodes dans un gaz ou un mélange gazeux.

Selon une première variante du procédé selon la présente invention, on produit la décharge luminescente à l'aide d'une onde électrique produite par commutation, quasi-commutation ou découpage.

Selon une deuxième variante, on produit la décharge à l'aide d'une onde électrique présentant des temps morts.

Selon une troisième variante, on peut avantageusement combiner les deux premières variantes et produire la décharge luminescente à l'aide d'une onde électrique produite par commutation, quasi-commutation ou découpage et qui présente des temps morts.

Selon la présente invention, l'onde électrique peut être avantageusement du type rectangulaire.

Selon la présente invention, l'onde électrique peut être avantageusement du type alternatif et notamment du type rectangulaire alternatif.

Selon la présente invention, l'amplitude et/ou la fréquence et/ou les temps morts de l'onde électrique produisant la décharge luminescente sont de préférence ajustables et/ou régulables.

Selon la présente invention, on peut en outre réguler l'intensité du courant traversant lesdites électrodes en agissant sur les temps morts.

La présente invention a également pour objet un dispositif de traitement d'au moins un substrat dans un plasma, mettant en oeuvre le procédé ci-dessus.

Ce dispositif comprend une enceinte ou chambre de réaction contenant un gaz ou un mélange gazeux et dans laquelle est placé ledit substrat, des électrodes disposées dans l'enceinte et un générateur d'ondes électriques relié auxdites électrodes en vue de produire une décharge luminescente dans ladite enceinte.

Selon la présente invention, ledit générateur électrique comprend une source de tension continue reliée auxdites électrodes par l'intermédiaire d'un circuit d'adaptation et de commutation susceptible de découper ladite tension continue en vue de produire une onde électrique alternative du type sensiblement rectangulaire dont deux impulsions successives sont séparées par un temps mort.

Selon une réalisation préférée, ledit circuit d'adaptation peut comprendre un transformateur dont le primaire est relié à ladite source de tension continue et dont le secondaire est relié auxdites électrodes, des moyens de commutation montés dans le circuit électrique du primaire dudit transformateur et des moyens de commande desdits moyens de commutation, lesdits moyens de commutation étant montés et commandés pour que le courant passe alternativement dans le primaire dudit transformateur dans un sens et dans l'autre en vue de produire ladite onde électrique.

Selon la présente invention, ledit générateur électrique comprend de préférence des moyens de régulation sensibles au courant traversant les électrodes et agissant sur ledit temps mort séparant deux impulsions pour maintenir ce courant constant.

Selon la présente invention, ledit générateur électrique comprend, de préférence, des moyens de régulation de la tension entre lesdites électrodes.

Selon la présente invention, ledit générateur électrique comprend, de préférence, des moyens de réglage et/ou de régulation de l'amplitude et/ou de la fréquence et/ou du temps mort desdites ondes électriques.

Selon la présente invention, et dans une variante de réalisation particulièrement intéressante, ladite source de tension continue comprend un redresseur alimenté par le réseau et fournissant à sa sortie ladite tension continue.

Selon la présente invention, ledit générateur électrique comprend, de préférence, un condensateur qui est monté entre ledit circuit d'adaptation et de commutation et l'électrode active ou chaude en vue d'isoler le générateur électrique de l'enceinte pour les potentiels continus qui peuvent apparaître dans le plasma.

La présente invention concerne en outre une structure particulière de ladite enceinte bien adaptée pour la mise en oeuvre du procédé ci-dessus et susceptible d'être avantageusement utilisée avec le dispositif ci-dessus.

Selon la présente invention, lesdites électrodes sont de préférence sensiblement cylindriques et disposées sensiblement concentriquement, ledit substrat étant placé à l'intérieur de l'électrode cylindrique centrale et cette électrode centrale se présentant sous la forme d'une grille.

Selon la présente invention, au moins l'une des extrémités de ladite électrode centrale peut être fermée par exemple par une grille sensiblement radiale.

La présente invention sera mieux comprise à l'étude d'un dispositif particulier de traitement de substrats dans un plasma décrit à titre d'exemple non limitatif et illustré par le dessin sur lequel :

- la figure 1 représente un schéma général du dispositif ;

et la figure 2 représente un schéma de l'onde électrique obtenue à l'aide du dispositif selon la figure 1.

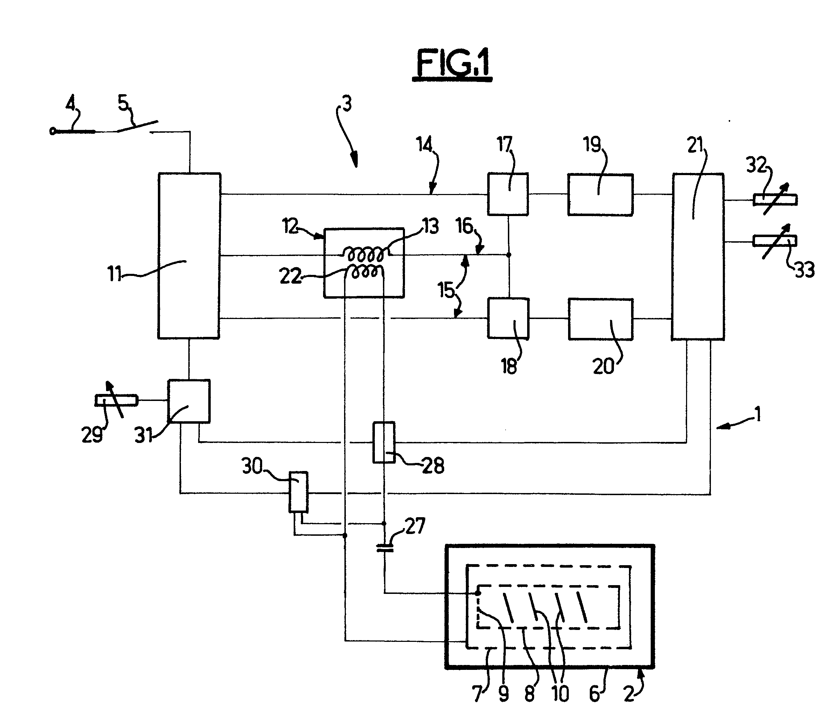

Le dispositif de traitement représenté sur la figure 1 et repéré d'une manière générale par la référence 1 comprend une enceinte ou chambre de réaction repérée d'une manière générale par la référence 2 et un générateur d'ondes électriques repéré d'une manière générale par la référence 3 et susceptible d'être alimenté par le réseau 4 couplé au générateur électrique 3 par l'intermédiaire d'un interrupteur général 5.

Dans l'exemple représenté, la chambre de réaction 2, représentée schématiquement, comprend une enveloppe cylindrique 6 réalisée par exemple en un matériau isolant tel que le quartz ou en un matériau conducteur tel que l'aluminium ou l'acier inoxydable et, à l'intérieur de cette enveloppe 6 deux électrodes 7 et 8. Les électrodes 7 et 8 sont formées par deux grilles sensiblement cylindriques de diamètres différents qui sont montées concentriquement à l'enveloppe 6 et à distance l'une de l'autre. Dans l'exemple, la grille périphérique 7 est ouverte à ses deux extrémités et la grille centrale 8 est fermée à l'une de ses extrémités par une grille plane radiale 9. On peut noter que l'électrode extérieure 7 pourrait être formée par un cylindre non perforé.

L'extrémité de l'enveloppe 6 opposée à la paroi d'extrémité 9 de l'électrode centrale 8 présente une porte, non représentée, d'accès à l'intérieur de l'enceinte 2 pour disposer à l'intérieur de l'électrode centrale 9 une série de substrats à traiter 10. Dans l'exemple représenté, les substrats 9 sont disposés sensiblement radialement aux électrodes 7 et 8, parallèlement les uns aux autres et sont de préférence portés par une nacelle, non représentée sur la figure, qui peut être simplement posée dans l'électrode centrale 8.

De manière habituelle, à l'enceinte 2 sont associés des moyens de pompage pour créer dans cette enceinte un vide relatif, des moyens pour introduire dans cette enceinte et évacuer de cette enceinte un gaz ou un mélange gazeux et d'autres moyens tels qu'un capteur de pression et un capteur de température, ces moyens n'ayant pas été représentés pour ne pas surcharger le dessin.

Le générateur électrique 1 comprend un redresseur 11 transformant la tension alternative du réseau 4 en une tension continue qui est appliquée au primaire 13 d'un transformateur 12 par l'intermédiaire de deux circuits extérieurs 14 et 15 assurant respectivement le passage du courant dans le primaire 12 dans un sens ou dans l'autre, les circuits 14 et 15 présentant dans ce but une branche commune 16 qui traverse le primaire 13.

Dans les circuits 14 et 15 sont montés respectivement des interrupteurs statiques 17 et 18 qui peuvent être commandés respectivement par des organes de commande électroniques 19 et 20 qui sont pilotés par un circuit électronique de régulation 21.

Les extrémités du secondaire 22 du transformateur 12 sont reliées respectivement aux électrodes 7 et 8, l'électrode extérieure ou périphérique 7 étant reliée à la masse.

On peut noter que le redresseur 10, le transformateur 12 et les interrupteurs 16 et 17 montés dans les circuits 13 et 14 forment un convertisseur qui pourrait avoir une toute autre structure.

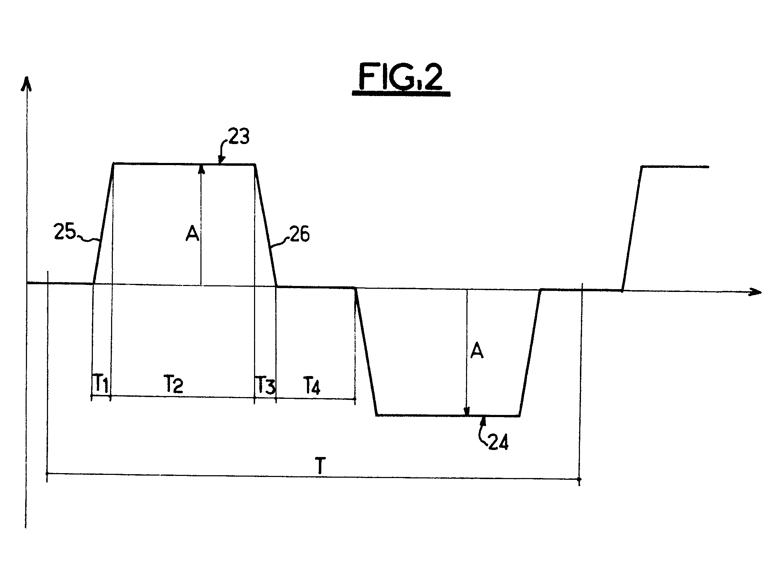

Le circuit électronique de régulation 21 élabore les signaux de commande des organes de commande 19 et 20 des interrupteurs statiques 17 et 18 de telle sorte que les interrupteurs 17 et 18 ferment et ouvrent respectivement les circuits 14 et 15 traversant le primaire 13 du transformateur 12 pour que les électrodes 7 et 8 soient soumises à une onde électrique de forme rectangulaire et alternative, dont deux impulsions successives sont séparées

6                    0082089

par un temps mort, du genre de celle représentée sur la figure 2 et par exemple transmise par le transformateur 12.

En référence à la figure 2, on voit que l'onde électrique produite par le générateur électrique 3 tel qu'il vient d'être décrit présente un signal ou impulsion positif 23 et un signal ou impulsion négatif 24 qui se reproduisent selon une période T. Le signal 23 et, de manière correspondante le signal 24, présente un front de montée 25 qui dure un temps $T_1$, une zone d'amplitude constante A qui dure un temps $T_2$ et un front de descente 26 qui dure un temps $T_3$, le signaux 23 et 24 étant séparés par un temps mort $T_4$. Les fronts 25 et 26 sont fortement inclinés et correspondent aux temps $T_1$ et $T_3$ de commutation des interrupteurs statiques 17 et 18.

Comme on peut le voir sur la figure 1, un condensateur 27 est monté entre le secondaire 22 du transformateur 12 et l'électrode centrale 8 qui, dans l'exemple représenté, est l'électrode active ou chaude. Ce condensateur 27 est destiné à isoler le générateur 3 de l'enceinte 2 vis à vis des potentiels continus qui peuvent apparaître entre les électrodes 7 et 8. En outre, on peut noter que le transformateur 12, outre sa fonction d'adaptation d'impédance, sert également à l'isolement de l'enceinte.

Le générateur électrique 3 comprend également des boucles de régulation de l'onde électrique représentée sur la figure 2.

Le générateur électrique 3 comprend en effet un capteur d'intensité 28 qui est monté dans le circuit du secondaire 22 du transformateur 12 entre le secondaire 22 et le condensateur 27 et qui mesure l'intensité du courant traversant les électrodes 7 et 8. Le signal de sortie du capteur d'intensité 28 est transmis au circuit électronique de régulation 21 qui en fonction de ce signal agit sur le temps mort $T_4$ séparant deux impulsions 23 et 24 en agissant sur les moments de commande des interrupteurs statiques 17 et 18. Dans le cas d'une régulation de ce type, l'amplitude A est préalablement choisie sur un potentiomètre 29.

Le générateur électrique 3 comprend également un capteur de tension 30 qui est sensible à la tension entre les électrodes 7 et 8 et dont le signal de sortie est envoyé à un circuit de commande 31 du redresseur 11 qui régule l'amplitude de la tension continue de sortie du redresseur 11. Dans cette régulation, le temps mort $T_4$ de l'onde électrique est préalablement fixé sur un potentiomètre 32 de réglage associé au circuit électronique de régulation 20.

Le potentiomètre 29 de réglage de l'amplitude de l'onde électrique est, dans l'exemple représenté, associé au circuit de commande 31 du redresseur 11.

Le générateur électrique 3 comprend également un potentiomètre 33 qui permet de régler la fréquence de l'onde électrique, ce potentiomètre 33 étant associé au circuit électronique de régulation 21.

Par ailleurs, les capteurs 28 et 30 peuvent également être reliés à des indicateurs extérieurs non représentés tels que des galvanomètres. Les informations qu'ils fournissent peuvent en outre être exploités par des limiteurs de courant et/ou de tension.

Tel qu'il vient d'être décrit, le générateur électrique 3 permet de régler aisément la puissance transmise aux électrodes en agissant sur l'amplitude, la fréquence et le temps mort de l'onde électrique qui déterminent la forme de cette onde. On peut en outre comme on l'a vu précédemment réguler cette puissance de deux manières soit en fixant l'amplitude A sur le potentiomètre 29 et la fréquence sur le potentiomètre 33 et en régulant automatiquement le temps mort soit en fixant le temps mort sur le potentiomètre 32 et la fréquence sur le potentiomètre 33 et en régulant automatiquement l'amplitude.

Dans un exemple d'exécution expérimenté, le générateur électrique 3 a été réalisé à l'aide de circuits intégrés et des essais ont été effectués avec succès.

Ces essais avaient pour but l'enlèvement de résines positives ou négatives sur des substrats. Les conditions étaient les suivantes. Le gaz était de l'oxygène, la fréquence était de 20 Kilo Herz, l'amplitude au secondaire du transformateur était de 330 Volts et le temps mort avait pour base 50 pour cent de la période. On effectuait la régulation de l'intensité en agissant sur le temps mort. La puissance était de 300 Watts et la pression dans l'enceinte était de 0,5 Torr.

Plusieurs séries de substrats ont été successivement traitées dans l'enceinte et on a constaté que tous les substrats étaient traités de manière équivalente et que par ailleurs le traitement effectué présentait une excellente uniformité longitudinale.

8 　0082089

En particulier, la partie centrale de chaque substrat était convenablement traitée.

La présente invention ne se limite pas à l'exemple ci-dessus décrit. En effet, on pourrait former une onde électrique de forme différente à l'aide d'un générateur électrique de structure différente sans sortir du cadre de la présente invention. On pourrait également utiliser d'autres gaz pour effectuer bien d'autres traitements que celui mentionné ci-dessus.

REVENDICATIONS

1. Procédé permettant de générer, dans un gaz ou un mélange gazeux, un plasma destiné à effectuer le traitement d'au moins un substrat dans ce plasma, tel que dépôt, gravure ou décapage notamment lors des opérations de fabrication de semi-conducteurs, de circuits intégrés ou de circuits hybrides, dans lequel on produit une décharge luminescente entre deux électrodes dans ledit gaz ou mélange gazeux, caractérisé par le fait qu'on produit la décharge luminescente à l'aide d'une onde électrique alternative produite par commutation, quasi-commutation ou découpage.

2. Procédé selon la revendication 1, caractérisé par le fait qu'on produit la décharge luminescente à l'aide d'une onde électrique alternative présentant des temps morts.

3. Procédé permettant de générer un plasma destiné à effectuer le traitement d'un substrat, dans lequel on produit une décharge luminescente entre deux électrodes dans un gaz ou un mélange gazeux, caractérisé par le fait qu'on produit la décharge luminescente à l'aide d'une onde électrique alternative présentant des temps morts.

4. Procédé selon la revendication 3, caractérisé par le fait que ladite onde électrique alternative est produite par commutation, quasi-commutation ou découpage.

5. Procédé selon l'une quelconque des revendications précédentes, caractérisé par le fait que l'amplitude de l'onde électrique alternative est du type rectangulaire.

6. Procédé selon l'une quelconque des revendications précédentes, caractérisé par le fait que l'amplitude et/ou la fréquence et/ou les temps morts de ladite onde électrique alternative sont ajustables et/ou réglables.

7. Procédé selon l'une quelconque des revendications précédentes, caractérisé par le fait qu'on régule l'intensité du courant traversant lesdites électrodes en agissant sur lesdits temps morts.

8. Dispositif de traitement d'au moins un substrat dans un plasma, mettant en oeuvre le procédé selon l'une quelconque des revendications précédentes, comprenant une enceinte contenant un gaz ou un mélange gazeux, des électrodes disposées dans ladite enceinte et un générateur d'ondes électriques relié auxdites électrodes en vue de produire une décharge luminescente dans ladite enceinte, caractérisé par le fait que ledit générateur électrique (3) comprend une source de tension continue (11) reliée auxdites électrodes (7, 8) par l'intermédiaire d'un circuit d'adaptation et de commutation (12, 17, 18) susceptible de découper ladite tension continue en vue de produire une onde électrique alternative du type sensiblement rectangulaire dont deux impulsions successives (23, 24) sont séparées par un temps mort ($T_4$).

9. Dispositif selon la revendication 8, caractérisé par le fait que ledit circuit d'adaptation et de commutation comprend un transformateur (12) dont le primaire (13) est relié à ladite source de tension continue (11) et dont le secondaire (22) est relié auxdites électrodes (7, 8) ; des moyens de commutation (17, 18) montés dans le circuit électrique du primaire dudit transformateur ; et des moyens de commande (19, 20, 21) desdits moyens de commutation, lesdits moyens de commutation étant montés et commandés pour que le courant passe alternativement dans un sens et dans l'autre dans le primaire (13) du transformateur en vue de produire ladite onde électrique.

10. Dispositif selon l'une des revendications 8 et 9, caractérisé par le fait que ledit générateur électrique (3) comprend des moyens de régulation (21, 28) sensibles au courant traversant lesdites électrodes et agissant sur ledit temps mort pour maintenir ce courant constant.

11. Dispositif selon l'une quelconque des revendications 8 à 10, caractérisé par le fait que ledit générateur électrique (3) comprend des moyens de régulation (30, 31) de la tension entre lesdites électrodes (7, 8).

12. Dispositif selon l'une quelconque des revendications 8 à 11, caractérisé par le fait que ledit générateur électrique (3) comprend des moyens de réglage et/ou de régulation de l'amplitude, de la fréquence et du temps mort de l'onde électrique.

13. Dispositif selon l'une quelconque des revendications 8 à 12, caractérisé par le fait que ladite source de tension continue comprend un redresseur (11) alimenté par le réseau (4) fournissant à sa sortie ladite tension continue.

14. Dispositif selon l'une quelconque des revendications 8 à 13, caractérisé par le fait que ledit générateur électrique (3) comprend un condensateur (27) qui est monté entre le circuit d'adaptation et de commutation et l'électrode active ou chaude.

15 Dispositif de traitement d'au moins un substrat dans un plasma, comprenant une enceinte contenant un gaz ou un mélange gazeux, des électrodes disposés dans ladite enceinte et un générateur d'ondes électriques alternatives relié auxdites électrodes en vue de produire une décharge luminescente dans ladite enceinte, caractérisé par le fait que lesdites électrodes (7, 8) sont sensiblement cylindriques et disposées sensiblement concentriquement et à distance l'une de l'autre, au moins l'électrode centrale étant formée par une grille sensiblement cylindrique et ledit substrat (9) étant placé à l'intérieur de cette électrode centrale (8).

16. Dispositif selon la revendication 15, caractérisé par le fait que ladite grille centrale est fermée à l'une de ses extrémités.

17. Dispositif selon la revendication 16, caractérisé par le fait que ladite grille centrale est fermée par une grille sensiblement radiale.

FIG.1

1/2

0082089

# FIG.2